# EUROPEAN PATENT SPECIFICATION

(11) **EP 4 358 141 B1**
(45) Date of publication and mention of the grant of the patent: **20.08.2025**
(21) Application number: 22202288.1
(22) Date of filing: 18.10.2022
(51) Int. Cl.: H10F 39/10

(54) **OPTICAL SENSOR AND METHOD FOR FABRICATING AN OPTICAL SENSOR**
OPTISCHER SENSOR UND VERFAHREN ZUR HERSTELLUNG EINES OPTISCHEN SENSORS
CAPTEUR OPTIQUE ET PROCÉDÉ DE FABRICATION D'UN CAPTEUR OPTIQUE

(43) Date of publication of application: 24.04.2024
(73) Proprietor: Infineon Technologies AG, 85579 Neubiberg (DE)
(72) Inventor: VIETZKE, Dirk, 85591 Vaterstetten (DE); MONO, Tobias, 01099 Dresden (DE)
(74) Representative: Lambsdorff & Lange Patentanwälte Partnerschaft mbB

(56) References cited:
- US-A1- 2017 171 485
- US-A1- 2021 029 311
- US-A1- 2021 141 068

## Description

### TECHNICAL FIELD

This disclosure relates in general to an optical sensor, in particular an optical sensor, wherein a pixel comprises field plates, as well as to a method for fabricating such an optical sensor.

### BACKGROUND

Optical sensors, in particular indirect time of flight (iToF) sensors, may use pixels with gate modulated storage nodes or memory nodes. A shallow trench isolation (STI) structure may be used to provide the required electrical isolation for these storage nodes. However, such optical sensors may exhibit a comparatively strong dark current due to the fact that a large part to the dark current is caused by electron-hole recombination at the STI interface. In order to improve such optical sensors, it may be desirable to provide a pixel with an electrical isolation structure which has a reduced impact on the dark current. Furthermore, it may also be desirable for such an electrical isolation structure to show a reduced impact on full well capacitance of the storage nodes compared to e.g. a junction isolation structure. Improved optical sensors as well as improved methods for fabricating optical sensors may help with solving these and other problems.

Document US 2021/029311 A1 shows an optical sensor according to the prior-art.

The problem on which the invention is based is solved by the features of the independent claims. Further advantageous examples are described in the dependent claims.

### SUMMARY

Various aspects pertain to an optical sensor comprising at least one pixel, the pixel comprising: a photoactive region configured to convert photons into charge carriers, a first and a second modulation gate configured to be modulated for indirect time of flight measurement, a first and a second storage node arranged on opposite sides of the photoactive region, the first and second storage nodes being configured to pin electrons generated in the photoactive region when the first, respectively the second modulation gate is active, and a first field plate arranged next to the first storage node at a first lateral side of the pixel and a second field plate arranged next to the second storage node at an opposite second lateral side of the pixel, wherein the first and second field plates are configured to be supplied with a negative bias voltage such that the first and second field plates provide electrical isolation for the first, respectively the second storage node.

Various aspects pertain to a method for fabricating at least one pixel for an optical sensor, the method comprising: fabricating a photoactive region configured to convert photons into charge carriers, fabricating a first and a second modulation gate configured to be modulated for indirect time of flight measurement, fabricating a first and a second storage node on opposite sides of the photoactive region, the first and second storage nodes being configured to pin electrons generated in the photoactive region when the first, respectively the second modulation gate is active, and fabricating a first field plate next to the first storage node at a first lateral side of the pixel and fabricating a second field plate next to the second storage node at an opposite second lateral side of the pixel, wherein the first and second field plates are configured to be supplied with a negative bias voltage such that the first and second field plates provide electrical isolation for the first, respectively the second storage node.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figure 1 shows a plan view of a pixel for an optical sensor, wherein the pixel comprises field plates configured to be supplied with a bias voltage such that the field plates provide electrical isolation for storage nodes of the pixel.
Figure 2 shows an optical sensor comprising a sensor part and a control part configured to control the sensor part.
Figures 3A and 3B show sectional views of exemplary pixels for an optical sensor, wherein in the example of Fig. 3A the pixel comprises field plates in the form of oxide structures and in the example of Fig. 3B the pixel comprises field plates in the form of trenches.
Figure 4 shows a plan view of a further pixel for an optical sensor.
Figure 5 shows an optical sensor unit configured to measure a distance between the sensor unit and an object and/or to measure a velocity of that object.
Figure 6 is a flow chart of an exemplary method for fabricating an optical sensor.

### DETAILED DESCRIPTION

In the following detailed description, directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only. It is to be understood that other examples may be utilized and structural or logical changes may be made.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted.

The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "coupled", or "connected" elements. However, it is also possible that the "bonded", "coupled", or "connected" elements are in direct contact with each other. Also, the term "exemplary" is merely meant as an example, rather than the best or optimal.

In several examples layers or layer stacks are applied to one another or materials are applied or deposited onto layers. It should be appreciated that any such terms as "applied" or "deposited" are meant to cover literally all kinds and techniques of applying layers onto each other. In particular, they are meant to cover techniques in which layers are applied at once as a whole as well as techniques in which layers are deposited in a sequential manner.

An efficient optical sensor and an efficient method for fabricating an optical sensor may for example reduce material consumption, ohmic losses, chemical waste, etc. and thus enable energy and/or resource savings. Improved optical sensors and improved methods for fabricating an optical sensor, as specified in this description, may thus at least indirectly contribute to green technology solutions, i.e. climate-friendly solutions providing a mitigation of energy and/or resource use.

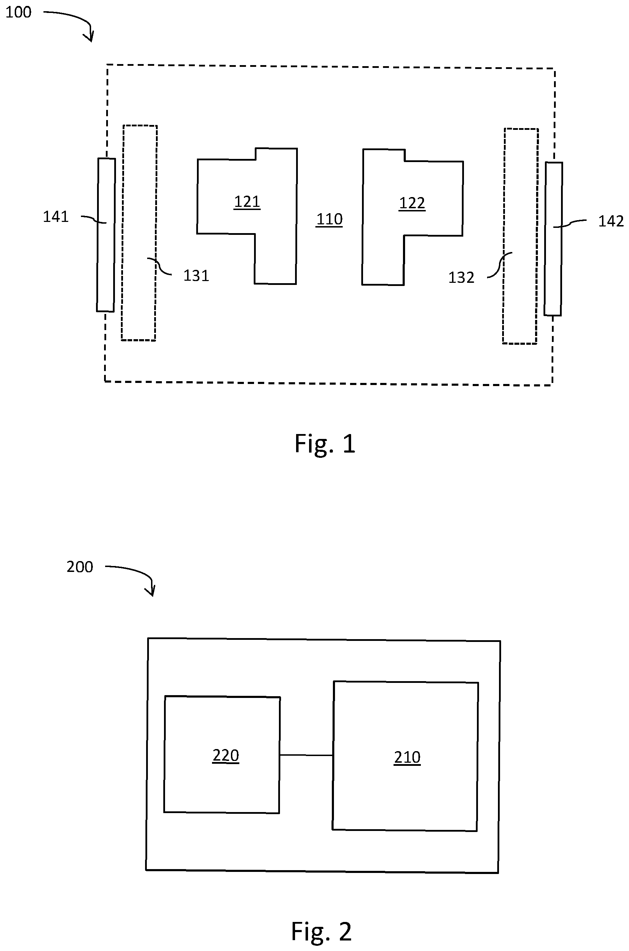

Figure 1 shows a plan view of a pixel 100 comprising a photoactive region 110, a first modulation gate 121, a second modulation gate 122, a first storage node 131, a second storage node 132, a first field plate 141 and a second field plate 142.

The pixel 100 may be part of an optical sensor, wherein the optical sensor may comprise a single pixel 100 or a plurality of pixels 100. The plurality of pixels may e.g. be arranged in an array. The array of pixels 100 may be part of a common substrate (this is indicated by the dashed outline of the pixel 100 in Fig. 1). The optical sensor may for example be an active-pixel sensor (APS). The optical sensor may for example be (part of) a time of flight (ToF) sensor device, in particular an indirect ToF sensor device.

The pixel 100 may comprise any suitable semiconductor material, e.g. Si and/or Ge. The pixel 100 may for example be configured to be sensitive in the infrared (IR) and/or the near-IR spectrum, e.g. for incident light at a wavelength of about 850nm and/or about 940nm. According to an example, the pixel 100 is configured for backside illumination. According to another example, the pixel 100 is configured for front side illumination (wherein the front side is the side shown in Fig. 1).

The photoactive region 110 is configured to convert incident photons into charge carriers, in particular into electrons and holes. The photoactive region 100 may in particular be configured to convert the incident photons into electrons and holes via the inner photoelectric effect. The photoactive region 110 may be fabricated in one or more epitaxial layers. The photoactive region 110 may for example comprise one or more n-type epitaxial layers, e.g. n-type epitaxial Si layers.

The first and second modulation gates 121, 122 are configured to be modulated for indirect time of flight measurements. The first and second modulation gates 121, 122 may essentially be arranged above the photoactive region 110. The modulation gates 121, 122 may in particular be arranged at the front side of the pixel 100. The first and second modulation gates 121, 122 may for example comprise or consist of a poly-Si structure.

The first storage node 131 and the second storage node 132 are arranged at opposite sides of the photoactive region 110 (in particular, the storage nodes 131, 132 may be arranged close to opposite lateral edges of the pixel 100). The first storage node 131 is configured to pin (or to bin) electrons generated in the photoactive region 110 when the first modulation gate 121 is active and the second storage node 132 is configured to pin (or to bin) electrons generated in the photoactive region 110 when the second modulation gate 122 is active.

The first and second storage nodes 131, 132 may be arranged below the front side of the pixel 100 (this is indicated in Fig. 1 by the dashed outlines of the storage nodes 131, 132). The storage nodes 131, 132 may for example be arranged closer to the front side of the pixel 100 than to a backside of the pixel 100.

According to an example, the first and second storage nodes 131, 132 are memory nodes of the pixel 100. According to another example, the first and second storage nodes 131, 132 are pinned diodes of the pixel 100. The storage nodes 131, 132 may be arranged within one or more epitaxial layers of the pixel 100. The storage nodes 131, 132 may for example comprise an n-doped region of the pixel 100. The storage nodes 131, 132 may be surrounded by p-wells of the pixel 100.

The first field plate 141 is arranged next to the first storage node 131 at a first lateral side of the pixel 100 and the second field plate 142 is arranged next to the second storage node 132 at an opposite second lateral side of the pixel 100 (wherein the lateral sides of the pixel 100 are indicated by dashed lines in Fig. 1). The first and second field plates 141, 142 are configured to be supplied with a negative bias voltage such that the first and second field plates 141, 142 provide electrical isolation for the first, respectively the second storage node 131, 132. In this context "providing electrical isolation" for the storage nodes 131, 132 may mean that the field plates 141, 142 are configured to electrically isolate the storage nodes 131, 132 towards one or more other pixels arranged next to the pixel 100. In this way, no electrons or almost no electrons generated in the one or more neighboring pixels can diffuse into the storage nodes 131, 132 (such electrons would contribute to a dark current).

The field plates 141, 142 may be used instead of a junction isolation or instead of a shallow trench isolation (STI) for isolating the storage nodes 131, 132. Using the field plates 141, 142 instead of an STI, the pixel 100 may exhibit a reduced dark current because a comparatively large contribution to the dark current comes from recombinations at the STI interface. This contribution can be eliminated by employing the field plates 141, 142 instead. Furthermore, the field plates 141, 142 may have less of an impact on full well capacitance of the storage nodes 131, 132 compared to a junction isolation.

The field plates 141, 142 may for example comprise a first, respectively a second polysilicon structure. The polysilicon structure may be arranged at or over the front side of the pixel 100, for example in the same plane as the modulation gates 121, 122. In this case, the field plates 141, 142 may be fabricated in the same process as the modulation gates 121, 122.

According to another example, the field plates 141, 142 may comprise a first, respectively a second trench which may extend into one or more epitaxial layers and possibly also into a bulk semiconductor part of the pixel 100. The trenches may for example extend into the pixel 100 from the front side of the pixel 100. The trenches comprise an electrically conductive coating or an electrically conductive filling such that the bias voltage can be applied.

In general, the field plates 141, 142 may comprise any suitable structure and any suitable material configured to be supplied with the bias voltage such that the storage nodes 131, 132 can be electrically isolated as described above. In order to provide the bias voltage, the field plates 141, 142 may be electrically coupled to contacts of the pixel 100 (in particular, the first field plate 141 may be coupled to a first contact and the second field plate 142 may be coupled to a second contact). The contacts may for example comprise metal traces.

According to an example, these contacts are at least partially arranged within a dielectric layer, wherein the dielectric layer is arranged above the photoactive region 110, above the first and second modulation gates 121, 122 and above the first and second field plates 141, 142 (in other words, the contacts are arranged at the front side of the pixel 100). The dielectric layer may in particular cover the modulation gats 121, 122 and the field plates 141, 142. The dielectric layer may for example comprise an oxide, e.g. silicon oxide.

According to another example, the contacts are at least partially arranged within a semiconductor substrate of the pixel 100. In this case, the contacts may comprise vias.

The field plates 141, 142 may have any suitable shape and any suitable dimensions. The field plates 141, 142 may for example have a rectangular footprint as shown in Fig. 1. The footprint may for example have a length measured along a longer side of the footprint in the range of about 1µm to about 10µm. The lower limit of this range may also be about 2µm, about 3µm, about 4µm, or about 5µm. The upper limit of this range may also be about 9µm, about 8µm, about 7µm, or about 6µm. The footprint may for example have a width measured along a shorter side of the footprint in the range of about 100nm to about 1µm. The lower limit of this range may also be about 150nm, about 200nm, about 300nm, about 400nm, or about 500nm. The upper limit of this range may also be about 900nm, about 800nm, about 700nm, or about 600nm.

According to an example, the pixel 100 may be part of an array of pixels, wherein the first field plate 141 is shared between the pixel 100 and a first adjacent pixel and/or wherein the second field plate 142 is shared between the pixel 100 and a second adjacent pixel. In other words, the first and second field plates 141, 142 are configured to provide electrical isolation for respective storage nodes of respective adjacent pixels.

In the example shown in Fig. 1 the pixel 100 comprises two storage nodes 131, 132 and two field plates 141, 142. However, the pixel 100 may comprise any suitable number of storage nodes and/or field plates, for example three storage nodes or four storage nodes and/or three field plates or four field plates. The further storage nodes and/or further field plates may for example be arranged at one or more of the remaining lateral sides of the pixel 100.

Figure 2 shows an optical sensor 200 comprising a sensor part 210 and a control part 220. The sensor part 210 comprises one or more pixels 100, in particular an array of pixels 100. The control part 220 is configured to control the sensor part 210.

For example, the control part 220 may be configured to control the modulation gates 121, 122 of the pixel 100. The control part 220 may also be configured to set a voltage value of the bias voltage for the field plates 141, 142. The control part 220 may in particular be configured to set the negative bias voltage to a first voltage value during a light detection state of the pixel 100 and to set the negative bias voltage to a second, higher voltage value (i.e. a more negative voltage value) during a readout state of the pixel. The second, higher voltage value may help with flushing the photo-electrons out of the storage nodes 131, 132 during read out of the pixel 100. This may speed up the readout process.

According to an example, the control part is configured to set identical voltage values for the bias voltage of the first field plate 141 and the second field plate 142. According to another example, the control part may set different voltage values for the bias voltage of the first field plate 141 on the one hand and the second field plate 142 on the other hand.

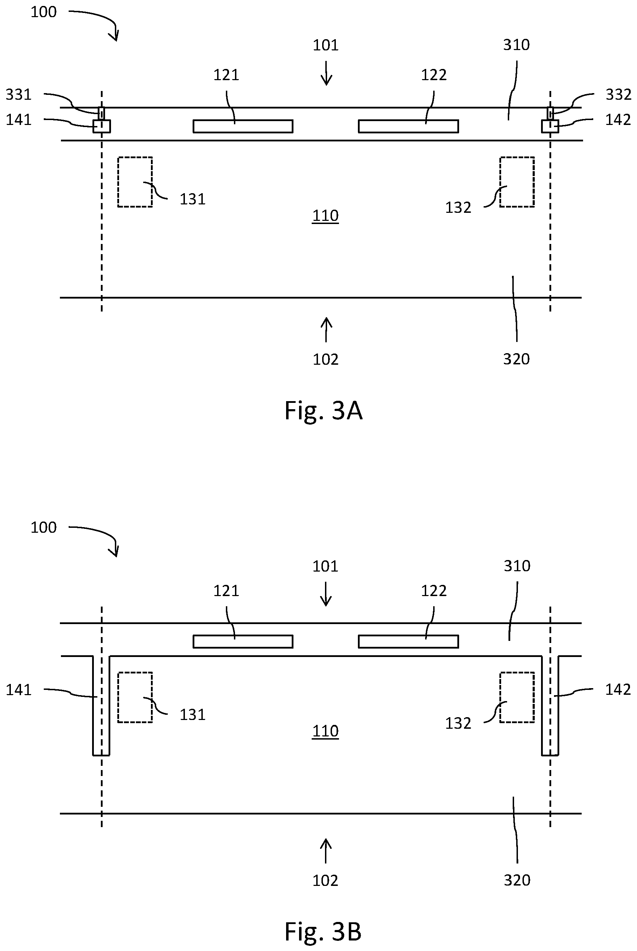

Figures 3A and 3B show sectional views of the pixel 100 according to two different specific examples.

In the example shown in Figure 3A, the pixel 100 comprises first and second field plates 141, 142 which comprise or consist of a first and a second polysilicon structure. The field plates 141, 142 (in particular, the polysilicon structures) may for example be arranged in (or over) a dielectric layer 310 of the pixel 100. The field plates 141, 142 may be arranged above a semiconductor part 320 of the pixel 100. The semiconductor part 320 may comprise one or more epitaxial layers, wherein the one or more epitaxial layers comprise the photoactive region 110. The semiconductor part 320 may further comprise a bulk semiconductor part, wherein the one or more epitaxial layers are arranged over the bulk semiconductor part. The field plates 141, 142 may be separated from the epitaxial layer(s) by the dielectric layer 310 or by a part of the dielectric layer 310 (i.e. a lower layer of a layer stack). In other words, in this example the field plates 141, 142 do not extend into the epitaxial layers. In particular, the dielectric layer 310 is arranged between the field plates 141, 142 and the storage nodes 131, 132. The dielectric layer 310 may comprise a layer stack. The dielectric layer 310 may comprise or consist of an oxide layer.

As shown in Fig. 3A, the first field plate 141 may be coupled to a first contact 331 and the second field plate 142 may be coupled to a second contact 332. The first and second contacts 331, 332 may e.g. comprise or consist of metal traces extending at least partially through the dielectric layer 310.

In the example shown in Figure 3B, the pixel 100 comprises first and second field plates 141, 142 which comprise or consist of a first trench and a second trench. The first and second trenches comprise an electrically conductive coating or the first and second trenches are filled with electrically conductive material such that the bias voltage can be applied. The trenches may be coupled to first and second contacts (not shown in Fig. 3B). The contacts may e.g. extend towards the front side 101 or towards the backside 102 of the pixel 100.

As shown in Figs. 3A and 3B, the pixel 100 may comprise the front side 101 and the backside 102. The backside 102 may be a side of the bulk semiconductor part of the pixel 100.

A thickness of the pixel 100 measured between the front side 101 and the backside 102 may for example be in the range of 4µm to 20µm. The lower limit of this range may also be about 6µm, or about 10µm and the upper limit may also be about 16µm, or about 12µm. A width of the pixel 100 measured between opposite lateral sides (the lateral sides are indicated by vertical dashed lines in Figs. 3A and 3B) may for example be in the range of 2µm to 10µm. The lower limit of the range may also be about 4µm or about 6µm and the upper limit may also be about 8µm.

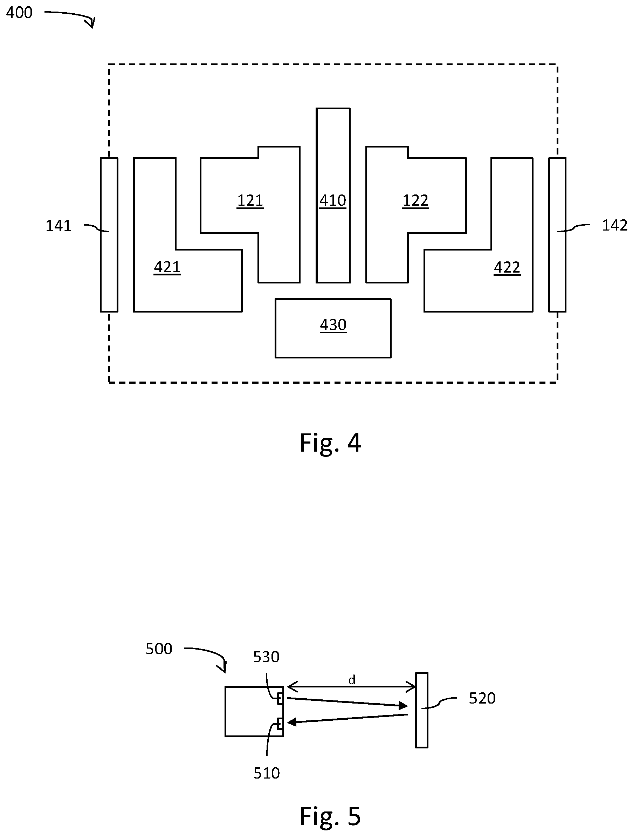

Figure 4 shows a plan view of a further pixel 400 which may be similar or identical to the pixel 100. The pixel 400 may comprise all components described with respect to the pixel 100 and it may further comprise the components described in the following.

The pixel 400 may for example comprise further polysilicon structures. The pixel 400 may for example comprise a third modulation gate 410 which may be arranged between the first and second modulation gates 121, 122. Similar to the first and second modulation gates 121, 122, the third modulation gate 410 may be configured to enable indirect time of flight measurements with the pixel 400.

The pixel 400 may for example comprise a first transfer gate 421 and a second transfer gate 422. The first transfer gate 421 may be configured to transfer electrons accumulated in the first storage node 131 to a first readout part (not shown) at the end of the integration time interval for readout of the pixel 400. Similarly, the second transfer gate 422 may be configured to transfer electrons accumulated in the second storage node 132 to a second readout part (also not shown). Note that the storage nodes 131, 132 are not shown in Fig. 4.

According to an example, the pixel 400 may further comprise a drain 430. The drain 430 may for example be arranged laterally next to the modulation gates 121, 122 and 410.

Figure 5 shows an exemplary optical sensor unit 500 which may comprise a sensor part 510 and optionally an emitter part 530. The sensor part 510 may comprise the optical sensor 200 with one or more pixels 100 or 400, in particular an array of pixels 100 or 400. The optical sensor unit 500 may for example be a time of flight sensor unit configured to measure a distance d to an object 520 and/or to measure a speed of the object 520. The optional emitter part 530 is configured for emitting photons. According to another example, the sensor part 510 and the emitter part 530 are part of separate units.

According to an example, the optical sensor unit 500 (and consequently, the pixel 100 or the pixel 400) is configured for front side illumination. According to another example, the optical sensor unit 500 (and consequently, the pixel 100 or the pixel 400) is configured for backside illumination.

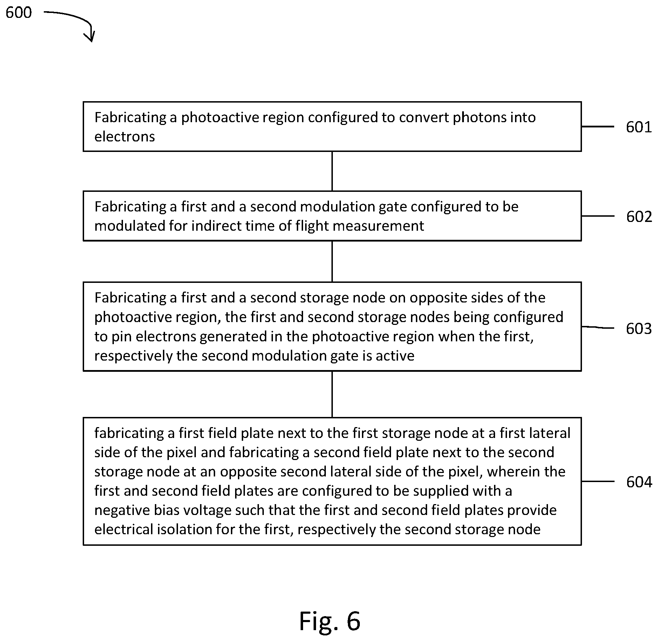

Figure 6 is a flow chart of a method 600 for fabricating at least one pixel for an optical sensor. The method 600 may for example be used to fabricate the pixels 100 and 400.

The method 600 comprises at 601 a process of fabricating a photoactive region configured to convert photons into charge carriers, at 602 a process of fabricating a first and a second modulation gate configured to be modulated for indirect time of flight measurement, at 603 a process of fabricating a first and a second storage node on opposite sides of the photoactive region, the first and second storage nodes being configured to pin electrons generated in the photoactive region when the first, respectively the second modulation gate is active, and at 604 a process of fabricating a first field plate next to the first storage node at a first lateral side of the pixel and fabricating a second field plate next to the second storage node at an opposite second lateral side of the pixel, wherein the first and second field plates are configured to be supplied with a negative bias voltage such that the first and second field plates provide electrical isolation for the first, respectively the second storage node.

According to an example of the method 600, fabricating the first and second field plates comprises fabricating a first and a second polysilicon structure at a first side of the at least one pixel.

## Claims

1. An optical sensor, comprising:
at least one pixel (100), comprising:
a photoactive region (110) configured to convert photons into charge carriers,
a first and a second modulation gate (121, 122) configured to be modulated for indirect time of flight measurement,
a first and a second storage node (131, 132) arranged on opposite sides of the photoactive region (110), the first and second storage nodes (131, 132) being configured to pin electrons generated in the photoactive region (110) when the first, respectively the second modulation gate (121, 122) is active, and
a first field plate (141) arranged next to the first storage node (131) at a first lateral side of the pixel (100) and a second field plate (142) arranged next to the second storage node (132) at an opposite second lateral side of the pixel (100),
**characterised in that**
the first and second field plates (141, 142) are configured to be supplied with a negative bias voltage such that the first and second field plates (141, 142) provide electrical isolation for the first, respectively the second storage node (131, 132).

2. The optical sensor of claim 1, wherein the first and second field plates (141, 142) comprise a first, respectively a second polysilicon structure.

3. The optical sensor of claim 1, wherein the first and second field plates (141, 142) comprise a first, respectively a second trench comprising an electrically conductive coating.

4. The optical sensor of one of the preceding claims, wherein the optical sensor comprises an array of pixels (100), and
wherein the field plates (141, 142) are configured to electrically isolate storage nodes (131, 132) of adjacent pixels (100) of the array of pixels (100) from one another.

5. The optical sensor of claim 4, wherein adjacent pixels (100) have shared field plates (141, 142).

6. The optical sensor of one of the preceding claims, further comprising:
an oxide layer (310) arranged between the field plates (141, 142) and the storage nodes.

7. The optical sensor of one of the preceding claims, wherein the modulation gates (131, 132) and the field plates (141, 142) have the same material or material composition.

8. The optical sensor of one of the preceding claims, wherein the negative bias voltage is a constant bias voltage.

9. The optical sensor of one of the preceding claims, wherein the first and second field plates (141, 142) are coupled to first and second contacts (331, 332),
wherein the first and second contacts (331, 332) are at least partially arranged within a dielectric layer (310), the dielectric layer (310) arranged above the photoactive region (110), above the first and second modulation gates (131, 132) and above the first and second field plates (141, 142), and
wherein the first and second contacts (331, 332) are configured to supply the first and second field plates (141, 142) with the negative bias voltage.

10. The optical sensor (200) of one of claim 9, wherein a control part (220) of the optical sensor (200) is configured to set the negative bias voltage to a first voltage value during a light detection state of the pixel (100) and to set the negative bias voltage to a second, higher voltage value during a readout state of the pixel.

11. A method (600) for fabricating at least one pixel for an optical sensor, the method (600) comprising:
fabricating (601) a photoactive region configured to convert photons into charge carriers,
fabricating (602) a first and a second modulation gate configured to be modulated for indirect time of flight measurement,
fabricating (603) a first and a second storage node on opposite sides of the photoactive region, the first and second storage nodes being configured to pin electrons generated in the photoactive region when the first, respectively the second modulation gate is active, and
fabricating (604) a first field plate next to the first storage node at a first lateral side of the pixel and fabricating (604) a second field plate next to the second storage node at an opposite second lateral side of the pixel,
wherein the first and second field plates are configured to be supplied with a negative bias voltage such that the first and second field plates provide electrical isolation for the first, respectively the second storage node.

12. The method (600) of claim 11, wherein fabricating (604) the first and second field plates comprises fabricating a first and a second polysilicon structure at a first side of the at least one pixel.

13. The method (600) of claim 11 or 12, wherein the first and second field plates are fabricated in the same process as the first and second modulation gates.

14. The method (600) of one of the claims 11 to 13, further comprising:
fabricating an oxide layer between the storage nodes and the field plates.

15. The method (600) of one of the claims 11 to 14, wherein the method (600) comprises fabricating an array of pixels for the optical sensor, and
wherein the field plates are arranged at boundaries between adjacent pixels of the array of pixels.

## Patentansprüche

1. Optischer Sensor, umfassend:
mindestens ein Pixel (100), umfassend:
eine photoaktive Region (110), die dazu ausgelegt ist, Photonen in Ladungsträger umzuwandeln,
ein erstes und ein zweites Modulationsgate (121, 122), die dazu ausgelegt sind, für eine indirekte Laufzeitmessung moduliert zu werden,
einen ersten und einen zweiten Speicherknoten (131, 132), die auf gegenüberliegenden Seiten der photoaktiven Region (110) angeordnet sind, wobei der erste und der zweite Speicherknoten (131, 132) dazu ausgelegt sind, Elektronen, die in der photoaktiven Region (110) generiert werden, zu pinnen, wenn das erste bzw. das zweite Modulationsgate (121, 122) aktiv ist, und
eine erste Feldplatte (141), die neben dem ersten Speicherknoten (131) an einer ersten lateralen Seite des Pixels (100) angeordnet ist, und eine zweite Feldplatte (142), die neben dem zweiten Speicherknoten (132) an einer gegenüberliegenden zweiten lateralen Seite des Pixels (100) angeordnet ist,
**dadurch gekennzeichnet, dass**
die erste und die zweite Feldplatte (141, 142) dazu ausgelegt sind, mit einer negativen Vorspannung versorgt zu werden, so dass die erste und die zweite Feldplatte (141, 142) elektrische Isolation für den ersten bzw. den zweiten Speicherknoten (131, 132) bereitstellen.

2. Optischer Sensor nach Anspruch 1, wobei die erste und die zweite Feldplatte (141, 142) eine erste bzw. eine zweite Polysiliciumstruktur umfassen.

3. Optischer Sensor nach Anspruch 1, wobei die erste und die zweite Feldplatte (141, 142) einen ersten bzw. einen zweiten Graben umfassen, der eine elektrisch leitfähige Beschichtung umfasst.

4. Optischer Sensor nach einem der vorhergehenden Ansprüche, wobei der optische Sensor ein Array von Pixeln (100) umfasst, und
wobei die Feldplatten (141, 142) dazu ausgelegt sind, Speicherknoten (131, 132) benachbarter Pixel (100) des Arrays von Pixeln (100) elektrisch voneinander zu isolieren.

5. Optischer Sensor nach Anspruch 4, wobei benachbarte Pixel (100) gemeinsam genutzte Feldplatten (141, 142) aufweisen.

6. Optischer Sensor nach einem der vorhergehenden Ansprüche, ferner umfassend:
eine Oxidschicht (310), die zwischen den Feldplatten (141, 142) und den Speicherknoten angeordnet ist.

7. Optischer Sensor nach einem der vorhergehenden Ansprüche, wobei die Modulationsgates (131, 132) und die Feldplatten (141, 142) das gleiche Material oder die gleiche Materialzusammensetzung aufweisen.

8. Optischer Sensor nach einem der vorhergehenden Ansprüche, wobei die negative Vorspannung eine konstante Vorspannung ist.

9. Optischer Sensor nach einem der vorhergehenden Ansprüche, wobei die erste und die zweite Feldplatte (141, 142) mit einem ersten und einem zweiten Kontakt (331, 332) gekoppelt sind,
wobei der erste und der zweite Kontakt (331, 332) zumindest teilweise innerhalb einer dielektrischen Schicht (310) angeordnet sind, wobei die dielektrische Schicht (310) oberhalb der photoaktiven Region (110), oberhalb der ersten und des zweiten Modulationsgates (131, 132) und oberhalb der ersten und der zweiten Feldplatte (141, 142) angeordnet ist, und
wobei der erste und der zweite Kontakt (331, 332) dazu ausgelegt sind, um die erste und die zweite Feldplatte (141, 142) mit der negativen Vorspannung zu versorgen.

10. Optischer Sensor (200) nach Anspruch 9, wobei ein Steuerteil (220) des optischen Sensors (200) dazu ausgelegt ist, die negative Vorspannung während eines Lichtdetektionszustands des Pixels (100) auf einen ersten Spannungswert einzustellen und die negative Vorspannung während eines Auslesezustands des Pixels auf einen zweiten, höheren Spannungswert einzustellen.

11. Verfahren (600) zum Fertigen mindestens eines Pixels für einen optischen Sensor, wobei das Verfahren (600) umfasst:
Fertigen (601) einer photoaktiven Region, die dazu ausgelegt ist, Photonen in Ladungsträger umzuwandeln,
Fertigen (602) eines ersten und eines zweiten Modulationsgates, die dazu ausgelegt sind, für eine indirekte Laufzeitmessung moduliert zu werden,
Fertigen (603) eines ersten und eines zweiten Speicherknotens auf gegenüberliegenden Seiten der photoaktiven Region, wobei der erste und der zweite Speicherknoten dazu ausgelegt sind, Elektronen, die in der photoaktiven Region generiert werden, zu pinnen, wenn das erste bzw. das zweite Modulationsgate aktiv ist, und Fertigen (604) einer ersten Feldplatte neben dem ersten Speicherknoten an einer ersten lateralen Seite des Pixels und Fertigen (604) einer zweiten Feldplatte neben dem zweiten Speicherknoten an einer gegenüberliegenden zweiten lateralen Seite des Pixels,
wobei die erste und die zweite Feldplatte dazu ausgelegt sind, mit einer negativen Vorspannung versorgt zu werden, so dass die erste und die zweite Feldplatte eine elektrische Isolation für den ersten bzw. den zweiten Speicherknoten bereitstellen.

12. Verfahren (600) nach Anspruch 11, wobei Fertigen (604) der ersten und zweiten Feldplatte Fertigen einer ersten und einer zweiten Polysiliciumstruktur an einer ersten Seite des mindestens einen Pixels umfasst.

13. Verfahren (600) nach Anspruch 11 oder 12, wobei die erste und die zweite Feldplatte in demselben Prozess wie das erste und das zweite Modulationsgatter gefertigt werden.

14. Verfahren (600) nach einem der Ansprüche 11 bis 13, ferner umfassend:
Fertigen einer Oxidschicht zwischen den Speicherknoten und den Feldplatten.

15. Verfahren (600) nach einem der Ansprüche 11 bis 14, wobei das Verfahren (600) Fertigen eines Arrays von Pixeln für den optischen Sensor umfasst, und
wobei die Feldplatten an Grenzen zwischen benachbarten Pixeln des Arrays von Pixeln angeordnet sind.

## Revendications

1. Capteur optique, comprenant :
au moins un pixel (100), comprenant :
une région photoactive (110) conçue pour convertir des photons en porteurs de charge,
une première et une deuxième grille de modulation (121, 122) conçues pour être modulées pour une mesure indirecte du temps de vol,
un premier et un deuxième nœud de stockage (131, 132) disposés sur des côtés opposés de la région photoactive (110), les premier et deuxième nœuds de stockage (131, 132) étant conçus pour piéger des électrons générés dans la région photoactive (110) quand la première, respectivement la deuxième grille de modulation (121, 122) est active, et
une première plaque de champ (141) disposée à côté du premier nœud de stockage (131) sur un premier côté latéral du pixel (100) et une deuxième plaque de champ (142) disposée à côté du deuxième nœud de stockage (132) sur un deuxième côté latéral opposé du pixel (100),
**caractérisé en ce que**
les première et deuxième plaques de champ (141, 142) sont conçues pour être alimentées avec une tension de polarisation négative, de sorte que les première et deuxième plaques de champ (141, 142) assurent une isolation électrique du premier, respectivement du deuxième nœud de stockage (131, 132).

2. Capteur optique selon la revendication 1, dans lequel les première et deuxième plaques de champ (141, 142) comprennent une première, respectivement une deuxième structure en silicium polycristallin.

3. Capteur optique selon la revendication 1, dans lequel les première et deuxième plaques de champ (141, 142) comprennent une première, respectivement une deuxième tranchée comprenant un revêtement électriquement conducteur.

4. Capteur optique selon une des revendications précédentes, le capteur optique comprenant une matrice de pixels (100), et
les plaques de champ (141, 142) étant conçues pour isoler électriquement les nœuds de stockage (131, 132) de pixels adjacents (100) de la matrice de pixels (100) l'un de l'autre.

5. Capteur optique selon la revendication 4, dans lequel les pixels adjacents (100) ont des plaques de champ (141, 142) partagées.

6. Capteur optique selon une des revendications précédentes, comprenant en outre :
une couche d'oxyde (310) disposée entre les plaques de champ (141, 142) et les nœuds de stockage.

7. Capteur optique selon une des revendications précédentes, dans lequel les grilles de modulation (131, 132) et les plaques de champ (141, 142) possèdent le même matériau ou la même composition de matière.

8. Capteur optique selon une des revendications précédentes, dans lequel la tension de polarisation négative est une tension de polarisation constante.

9. Capteur optique selon une des revendications précédentes, dans lequel les première et deuxième plaques de champ (141, 142) sont couplées aux premier et deuxième contacts (331, 332),
dans lequel les premier et deuxième contacts (331, 332) sont au moins partiellement disposés à l'intérieur d'une couche diélectrique (310), la couche diélectrique (310) étant disposée au-dessus de la région photoactive (110), au-dessus des première et deuxième grilles de modulation (131, 132) et au-dessus des première et deuxième plaques de champ (141, 142), et
dans lequel les premier et deuxième contacts (331, 332) sont conçus pour alimenter les première et deuxième plaques de champ (141, 142) avec la tension de polarisation négative.

10. Capteur optique (200) selon la revendication 9, une partie commande (220) du capteur optique (200) étant conçue pour régler la tension de polarisation négative à une première valeur de tension dans un état de détection de lumière du pixel (100) et pour régler la tension de polarisation négative à une deuxième valeur de tension, plus élevée, dans un état de lecture du pixel.

11. Procédé (600) destiné à fabriquer au moins un pixel pour un capteur optique, le procédé (600) comprenant :
la fabrication (601) d'une région photoactive conçue pour convertir des photons en porteurs de charge,
la fabrication (602) d'une première et d'une deuxième grille de modulation conçues pour être modulées pour une mesure indirecte du temps de vol,
la fabrication (603) d'un premier et d'un deuxième nœud de stockage sur des côtés opposés de la région photoactive, les premier et deuxième nœuds de stockage étant conçus pour piéger des électrons générés dans la région photoactive quand la première, respectivement la deuxième grille de modulation est active, et
la fabrication (604) d'une première plaque de champ à côté du premier nœud de stockage sur un premier côté latéral du pixel et la fabrication (604) d'une deuxième plaque de champ à côté du deuxième nœud de stockage sur un deuxième côté latéral opposé du pixel,
dans lequel les première et deuxième plaques de champ sont conçues pour être alimentées avec une tension de polarisation négative, de sorte que les première et deuxième plaques de champ assurent une isolation électrique du premier, respectivement du deuxième nœud de stockage.

12. Procédé (600) selon la revendication 11, dans lequel la fabrication (604) des première et deuxième plaques de champ comprend la fabrication d'une première et d'une deuxième structure en silicium polycristallin sur un premier côté de l'au moins un pixel.

13. Procédé (600) selon la revendication 11 ou 12, dans lequel les première et deuxième plaques de champ sont fabriquées dans le même processus que les première et deuxième grilles de modulation.

14. Procédé (600) selon une des revendications 11 à 13, comprenant en outre :
la fabrication d'une couche d'oxyde entre les nœuds de stockage et les plaques de champ.

15. Procédé (600) selon une des revendications 11 à 14, le procédé (600) comprenant la fabrication d'une matrice de pixels pour le capteur optique, et
les plaques de champ étant disposées à des limites entre pixels adjacents de la matrice de pixels.
